# NEUE EUROPÄISCHE PATENTSCHRIFT

(11) **EP 2 695 501 B2**
(45) Veröffentlichungstag und Bekanntmachung des Hinweises auf die Entscheidung über den Einspruch: **20.03.2024**
(45) Hinweis auf die Patenterteilung: 02.06.2021
(21) Anmeldenummer: 12712660.5
(22) Anmeldetag: 04.04.2012
(51) Int. Cl.: H05K 7/14, F03D 9/00, H02M 7/00, H02J 3/38

(54) **SCHALTSCHRANKANORDNUNG EINER VORRICHTUNG ZUR ERZEUGUNG ELEKTRISCHER ENERGIE**
SWITCHGEAR CABINET ARRANGEMENT OF A DEVICE FOR PRODUCING ELECTRIC ENERGY
ENSEMBLE D'ARMOIRES DE COMMANDE POUR UN DISPOSITIF DE PRODUCTION D'ÉLECTRICITÉ

(30) Priorität: 04.04.2011 DE 102011001786
(43) Veröffentlichungstag der Anmeldung: 12.02.2014
(73) Patentinhaber: ConverterTec Deutschland GmbH, 47906 Kempen (DE)
(72) Erfinder: EICHLER, Markus, 79761 Waldshut-Tiengen (DE); NOWAK, Hans-Georg, 41238 Mönchengladbach (DE); HITPAß, Marianne, 47800 Krefeld (DE)
(74) Vertreter: Cohausz & Florack
(86) Internationale Anmeldenummer: PCT/EP2012/056219
(87) Internationale Veröffentlichungsnummer: WO 2012/136726

(56) Entgegenhaltungen:
- EP-A2- 0 677 916
- EP-B1- 1 903 848
- WO-A1-2010/108928
- DE-A1-102006 050 289
- DE-A1-102008 034 417
- DE-A1-102008 037 449
- DE-U1-202006 008 138
- US-B2- 7 545 052
- US-B2- 7 859 838
- Andresen Bjorn, Birk Jens: "A high power density converter system for the Gamesa GlOx 4,5 MW Wind turbine", European Conference on Power Electronics and Applications, 4 January 2008 (2008-01-04), pages 1-8,
- Birk Jens, Andresen Bjorn,: "Parallel-connected converters for optimizing efficiency, reliability andgrid harmonics in a wind turbine", European Conference on Power Electronics and Applications, 4 January 2008 (2008-01-04), pages 1-7,

## Beschreibung

Die Erfindung betrifft eine Schaltschrankanordnung einer Vorrichtung zur Erzeugung elektrischer Energie, wobei die Schaltschrankanordnung mindestens zwei separate Leistungsschaltschränke aufweist.

Elektronische Komponenten, wie Umrichter oder Filter, insbesondere von Vorrichtungen zur Erzeugung elektrischer Energie, in Leistungsschaltschränken anzuordnen, ist aus dem Stand der Technik bekannt. Windenergieanlagen werden häufig mit doppelt gespeisten Asynchronmaschinen ausgestattet, da auf diese Weise nur Teilleistungen über die Umrichter der Anlage transportiert werden müssen. Bei Drehzahlen unterhalb der Synchrondrehzahl des Generators sinkt jedoch der Wirkungsgrad der Anlage. Deshalb kommen zunehmend Synchronmaschinen mit Vollumrichter zum Einsatz. Bei diesen Systemen wird jedoch die gesamte an das Netz abzugebende Leistung über einen Umrichter geführt, so dass diese entsprechend dimensioniert und skalierbar aufgebaut sein müssen. Darüber hinaus treten durch die geforderten größeren Leistungen beispielsweise zusätzliche Herausforderungen an eine Kühlung bei gleichzeitig kompakter Bauweise der Schaltschränke auf.

Die Druckschrift EP1903848B1 beschreibt einen modularen Frequenzumrichter, bei welchem der Leistungselektronikteil mit Rädern versehen ist, sowie einen Installationsschrank zum Aufnehmen des Leistungselektronikteils. Um den Leistungselektronikteil mit dem Rest des Frequenzumrichters zu verbinden, sind aufwendige und kostspielige Steckverbindungen notwendig.

Die Druckschrift US 7,545,052 B2 beschreibt ein Verfahren, welches die Effizienz und die Verlässlichkeit von Umrichtermodulen in einer Stromerzeugungsvorrichtung in einer Windenergieanlage verbessern soll. Hierzu weist die Windenergieanlage eine Mehrzahl von Umrichtermodulen, auch Konvertermodule genannt, auf, welche sowohl generator- als auch netzseitig parallel geschaltet sind und wobei die Konvertermodule in Abhängigkeit von einem Parameter unabhängig voneinander aus- und eingeschaltet werden können. Um Überhitzung zu vermeiden, sollen die Konvertermodule beispielsweise abwechselnd betrieben werden oder entsprechend der durch den Generator produzierten Leistung ein- und ausgeschaltet werden. Die Konvertermodule durchlaufen beim Ein- bzw. Ausschalten mehrere spezifische Schaltzustände, welche von einer zentralen CPU gesteuert werden. Dies hat eine aufwendige Verkabelung zwischen der zentralen CPU und den Konvertermodulen zur Folge. Darüber hinaus muss bei einem Defekt das vollständige Modul ausgetauscht werden.

Ebenso ist aus der WO 2010/108928 ein Verfahren zur Gewinnung von Energie durch eine Windenergieanlage bekannt, bei welchem für eine einzelne Windturbine mehrere parallel geschaltete Konvertermodule vorgesehen sind. Die Konvertermodule können durch eine zentrale Turbinensteuereinheit nach Bedarf zugeschaltet oder abgeschaltet werden.

Die Druckschrift US 7,859,838 B2 betrifft eine Anordnung zur Platzierung eines Umrichters bzw. Frequenzkonverters in einem Schaltschrank. Der Rahmen des Schaltschranks soll hierbei modular aufgebaut sein, sodass die Komponenten des Frequenzkonverters in den Schaltschrankrahmenmodulen installiert werden können, bevor der Schaltschrank zum Einsatzort gebracht wird. Nachteilig hierbei ist jedoch, dass die einzelnen Komponenten des Frequenzkonverters auf verschiedene Schränke verteilt werden, was eine weiterhin aufwendige Verkabelung erfordert. Nach der Installation in der Fabrik ist eine spätere Skalierbarkeit vor Ort nur mit hohem Aufwand möglich. Zusätzlich benötigen die einzelnen Rahmenmodule vergleichsweise viel Platz.

Der vorliegenden Erfindung liegt somit die technische Aufgabe zugrunde, eine optimale Skalierbarkeit von Vorrichtungen zur Erzeugung elektrischer Energie bei gleichzeitig einfacher Installation und Wartung der Leistungsschaltschränke trotz eines geringen Platzbedarfs zu erzielen.

Die technische Aufgabe wird erfindungsgemäß mit Schaltschrankanordnung gemäß Patentanspruch 1 gelöst. Erfindungsgemäß weisen die Leistungsschaltschränke jeweils einen maschinenseitigen Anschluss, ein Leistungsmodul, einen netzseitigen Anschluss und eine dezentrale Steuerungseinheit auf, wobei das Leistungsmodul einen maschinenseitigen Umrichter, einen netzseitigen Umrichter, einen Gleichspannungszwischenkreis und einen Chopper aufweist und wobei die Leistungsschaltschränke über den netzseitigen Anschluss und optional über den maschinenseitigen Anschluss elektrisch parallel miteinander verbunden sind. Die maschinenseitigen Anschlüsse können elektrisch parallel miteinander verbunden und dann mit der Wicklung der Maschine verbunden werden. Bei Verwendung einer Maschine mit getrennten Wicklungen ist es auch denkbar, dass die maschinenseitigen Anschlüsse elektrisch getrennt mit den jeweiligen Wicklungen verbunden werden.

Das Vorsehen dieser Komponenten in den jeweiligen Leistungsschaltschränken und deren Zusammenwirken erlaubt eine optimale Skalierbarkeit einer Vorrichtung zur Erzeugung elektrischer Energie. Es werden nämlich im Wesentlichen eigenständige Leistungsschaltschränke zur Verfügung gestellt, mit denen auf einfachste Weise mittels Anpassen der Anzahl der Leistungsschaltschränke die Leistung skaliert werden kann.

Aufgrund der im Leistungsschaltschrank vorgesehenen maschinen- und netzseitigen Anschlüsse, dem Leistungsmodul, welches neben den netzseitigen und maschinenseitigen Umrichtern auch einen Chopper zum Kurzschließen des jeweiligen Zwischenkreises aufweist, wird es ermöglicht, die Komponenten so anzuordnen, dass nur minimale Verbindungswege zwischen den einzelnen Komponenten entstehen. Diese kurzen Verbindungswege führen einerseits zu einer hohen Leistungsdichte und somit zu einer sehr kompakten Anordnung und andererseits dadurch auch zu Kosteneinsparungen. Die Auswahl der Komponenten, welche die Leistungsschaltschränke aufweisen, ermöglicht des Weiteren, einen optimalen Leistungsfluss zu erzielen, denn es sind außer den maschinenseitigen und netzseitigen Anschlüssen keine Querverbindungen zu anderen Leistungsschaltschränken notwendig, was komplizierte Kreuzungen von Kabelwegen zur Folge hätte.

Vor allem das Vorsehen einer dezentralen Steuerungseinheit ermöglicht eine Optimierung der Flexibilität in Bezug auf die Installation der Leistungsschaltschränke und der Skalierbarkeit. Die einzelnen Komponenten eines Leistungsschaltschranks müssen nicht einzeln angesteuert werden, sondern können alle intern von der dezentralen Steuerungseinheit angesprochen werden. Diese kann bevorzugt mit allen relevanten implementierten Komponenten, also allen Aktoren und Sensoren des Leistungsschaltschranks kommunizieren, insbesondere jedoch mit dem Leistungsmodul. Auch Temperatur- oder Feuchtigkeitssensoren zur Überwachung können ausgelesen oder überwacht werden. Aufgrund der kurzen Signalwege erlaubt eine dezentrale Steuereinrichtung die Verwendung einfacher elektrischer Datenverbindungen beispielsweise zu den Treibern der IGBT's und anderen Sensoren und Aktoren. Bei langen Signalwegen kommt lediglich die Verwendung von Lichtwellenleiter aufgrund der starken elektromagnetischen Störungssignale in Frage. Dies hat zur Folge, dass die optischen Signale häufig wieder in elektrische Signale umgewandelt werden müssen. Die Kommunikation mit den in dem Leistungsschaltschrank vorgesehen Komponenten wird demnach deutlich vereinfacht. Die dezentralen Steuerungseinheiten können über einfache Datenverbindungen mit einer zentralen Steuerungseinheit verbunden werden. Die Anzahl der nötigen Verbindungen und Verkabelungen wird also auf ein Minimum reduziert. Vorzugsweise sind die dezentralen Steuerungseinheiten so ausgebildet, dass diese über eine Verbindung über einen Lichtwellenleiter beispielsweise mit einer zentralen Steuereinheit, kommunizieren können. Die dezentralen Steuerungseinheiten können dann beispielsweise mit weiteren Systemen, wie weiteren Steuerungseinheiten, kommunizieren. Hierbei kann sowohl eine Stern, Ring-, Reihen- und/oder Bustopologie der dezentralen Steuerungseinheiten vorgesehen sein.

Die maschinenseitigen Anschlüsse der mindestens zwei Leistungsschaltschränke werden, vorzugsweise über weitere Komponenten, wie Schalter oder auch einen Generatoranschlussschrank, welcher Schalter und/oder Schutzelemente aufweisen kann, an eine elektrische Maschine, beispielsweise einen Generator oder einen Motor angeschlossen. Die mindestens zwei Leistungsschaltschränke werden hierbei parallel geschaltet. Der maschinenseitige Anschluss ist vorzugsweise als Anschlussschiene ausgebildet, jedoch sind auch andere Verbindungen, wie Kabelverbindungen, denkbar. Anschlussschienen sind mechanisch robust und stellen auf einfache Weise die notwendigen Querschnitte zur Verfügung, um hohe Leistungen zu transportieren. Darüber hinaus lassen sie eine einfache, ebenfalls große Querschnitte aufweisende Verbindung zwischen zwei Anschlussschienen zu. Auch netzseitig können Anschlussschienen zur Parallelschaltung der Leistungsschaltschränke verwendet werden.

Der maschinenseitige und der netzseitige Umrichter des Leistungsmoduls weist elektronische Leistungsschalter auf, um Wechselstrom in Gleichstrom umzuwandeln oder andersherum. Diese elektronischen Schalter können beispielsweise Dioden, Transistoren, Integrated-Gate-Communicated-Thyristoren (IGCT) oder vorzugsweise Insulated-Gate-Bipolar-Transistoren (IGBT) sein. Letztere erlauben eine nahezu leistungslose Ansteuerung bei überdurchschnittlicher Robustheit und eine kompakte Bauweise. Diese elektronischen Leistungsschalter sind insbesondere so ausgebildet, dass sie einzeln oder als Modul zu mehreren elektronischen Leistungsschaltern in oder auf das Leistungsmodul montiert werden können.

Die energetische Verkopplung der beiden durch den Umrichter elektrisch verbundenen Stromnetze auf einer gemeinsamen Gleichspanhungsebene wird durch Kondensatoren erzielt, welche den Gleichspannungszwischenkreis bilden.

Das Vorsehen eines Choppers ermöglicht es, mittels eines elektronischen Leistungsschalters elektrische Energie über einen sogenannten Bremswiderstand in Wärmeenergie umzuwandeln und abzuführen. Als elektronischer Leistungsschalter kommt insbesondere wieder ein IGBT in Betracht, andere elektronische Leistungsschalter sind jedoch auch möglich. Das Vorsehen eines Choppers in jedem Leistungsschaltschrank ist besonders vorteilhaft, da somit in jedem Gleichspannungszwischenkreis Energie abgeführt werden kann. Die Chopper können daher an die jeweilige Leistung des einzelnen Schaltschranks angepasst sein. Bei einer Erweiterung der Vorrichtung fällt zudem eine neue Dimensionierung des Choppers, wie sie bei parallel geschalteten Gleichspannungszwischenkreisen notwendig wäre, weg. Zudem fallen Sicherungsmaßnahmen aufgrund der begrenzten über den Chopper abzuführenden Energie weg. Grundsätzlich kann der Chopper beispielsweise über Kabelverbindungen beliebig im Leistungsschaltschrank positioniert werden. Es ist allerdings besonders vorteilhaft, wenn der Chopper zwischen dem netzseitigen und dem maschinenseitigen Umrichter auf einer die Kondensatoren des Gleichspannungszwischenkreises aufweisender Gleichstromverschienung angeordnet ist. Hierdurch wird eine besonders kurze, symmetrische und unmittelbare Anbindung an den Gleichspannungszwischenkreis erreicht, was sich positiv auf die Kompaktheit der Leistungsschaltschränke auswirkt und eine gleichmäßige thermische Belastung der Kondensatoren ermöglicht. Des Weiteren ist es möglich, den elektronischen Leistungsschalter und den Widerstand des Choppers als gemeinsame Einheit zu montieren, oder aber auch, falls die Bauart des Widerstandes dies nicht zulässt, den Widerstand räumlich getrennt vom Leistungsschalter zu montieren.

Bei der Verwendung einer Gleichstromverschienung kann einfach über zwei Leiterebenen mit einer dazwischen liegenden Isolierung der Gleichspannungszwischenkreis mit sehr niedriger Induktivität realisiert werden. Dies führt zu einer besonders kompakten Bauweise des Leistungsmoduls. Für Drei-Level-Umrichter kann entsprechend eine dritte Gleichstromleiterebene in der Gleichstromverschienung vorgesehen sein, so dass ohne Änderung des mechanischen Aufbaus der Leistungsschaltschränke eine Schaltschrankanordnung für den Niederspannungs- als auch für den Mittelspannungsbetrieb zur Verfügung gestellt werden kann.

Das Leistungsmodul mit netzseitigem Umrichter, Gleichspannungszwischenkreis, Chopper und maschinenseitigem Umrichter ist über die beiden Umrichter vorzugsweise über Kupferschienen mit den netz- und/oder maschinenseitigen Anschlüssen des Schaltschranks verbunden. Allerdings können auch weitere Komponenten zwischen Leistungsmodul und netz- und maschinenseitigen Anschlüssen vorhanden sein, welche ebenfalls über Kupferschienen an das Leistungsmodul angebunden sind. Kupferschienen ermöglichen eine besonders verlustarme elektrische Verbindung. Allerdings ist es auch denkbar, entsprechend verlustarm ausgebildete Kabelverbindungen vorzusehen.

Hierdurch wird ein weitestgehend modularer Aufbau der Leistungsschaltschrankkomponenten erzielt, sodass der Austausch von einzelnen defekten Komponenten ohne zusätzliche Hilfsmittel durchgeführt werden kann.

Ein Leistungsschaltschrank ist vorzugsweise für Leistungen von typischerweise bis zu 1 MW ausgelegt, wobei sowohl Niederspannung bis zu 1kV als auch Mittelspannungen von bis zu 30kV verwendet werden können. Es sind selbstverständlich aber auch größere Leistungen pro Leistungsschaltschrank denkbar. Eine Skalierung der Leistung der Leistungsschaltschränke kann beispielsweise einerseits durch eine Anpassung von Typ und/oder Anzahl der elektronischen Leistungsschalter erfolgen und/oder andererseits besonders einfach durch das Vorsehen einer unterschiedlichen Anzahl von erfindungsgemäßen Leistungsschaltschränken.

Es ist insbesondere vorteilhaft, wenn in einem Leistungsschaltschrank die Anordnung der Komponenten im Wesentlichen der Richtung des Leistungsflusses entspricht. Es ist eine Anordnung der Komponenten im Wesentlichen in einer Reihe bevorzugt. Hierbei ist die Reihenfolge der Komponenten: maschinenseitiger Anschluss, maschinenseitiger Umrichter, Gleichspannungszwischenkreis mit Chopper, netzseitiger Umrichter und netzseitiger Anschluss. Auf Grund der einfachen Zugänglichkeit und thermischer Effekte ist eine im Wesentlichen vertikale Anordnung der Komponenten besonders bevorzugt, wobei die Anordnung der Komponenten sowohl von oben nach unten als auch von unten nach oben entsprechend der genannten Reihenfolge erfolgen kann.

Insgesamt lässt sich durch eine erfindungsgemäße Schaltschrankanordnung ein kostensparender, kompakter Aufbau mit minimalen Verbindungsstrecken zwischen den Komponenten und dadurch mit einem optimalen Leistungsfluss und hoher Leistungsdichte bei sehr guter Skalierbarkeit realisieren.

Alternativ zum netzseitigen parallelen Anschluss der Leistungsschaltschränke können die Leistungsschaltschränke gemäß einer ersten alternativen Ausgestaltung der Schaltschrankanordnung jeweils einzeln über zugeordnete Sekundärwicklungen eines oder mehrerer Transformatoren an das Netz angebunden sein. Hier können Transformatoren mit je einer Primär- und einer Sekundärwicklung verwendet werden oder auch ein Transformator mit je einer Primär- und mehreren Sekundärwicklungen. Dies verhindert, dass sich Kreisströme zwischen mehreren sowohl maschinen- als auch netzseitig parallel verbundenen Leistungsschaltschränken ausbilden.

Gemäß der erfindungsgemäßen Schaltschrankanordnung weist das Leistungsmodul eine plattenförmige Gleichstromverschienung auf, welche auf einer ersten Seite die Leistungsschalter und einen Chopper aufweist und auf einer zweiten Seite die Kondensatoren des Gleichspannungszwischenkreises aufweist.

Durch die Gleichstromverschienung und die Anbindung der Leistungsschalter und des Choppers auf der einen Seite und der Kondensatoren des Gleichspannungszwischenkreise auf der anderen Seite der Gleichstromverschienung wird erfindungsgemäß eine sehr platzsparende Anordnung der Leistungsmodule, welche dem entsprechend eine hohe Leistungsdichte aufweisen, erreicht werden. Hierdurch wird auch ein einfacher Zugriff und somit eine einfache Installation und eine einfache Wartung der elektronischen Leistungsschalter ermöglicht.

Die Kondensatoren können insbesondere über Anschlusselemente eines ersten Rastermaßes leitend mit der Gleichstromverschienung verbunden werden, während der mindestens eine elektronische Leistungsschalter über Anschlusselemente eines zweiten Rastermaßes leitend mit der Gleichstromverschienung verbunden ist.

Das zweite Rastermaß der Gleichstromverschienung ermöglicht den variablen Anschluss von einem aber auch von mehreren elektronischen Leistungsschaltern an die Gleichstromverschienung, so dass eine einfache Skalierbarkeit der Schaltungsanordnung gegeben ist. Anschlusselemente werden vorzugsweise durch Kontaktlöcher in der jeweiligen Metallplatte des elektrischen Anschlusspols der Gleichstromverschienung gebildet, so dass die einzelnen Kondensatoren und elektronischen Leistungsschalter elektrisch leitend mit der Gleichstromverschienung verbunden werden können. Das erste Rastermaß und das zweite Rastermaß können entweder identisch oder voneinander verschieden ausgebildet sein. Der Platzbedarf wird hierdurch weiter verringert und darüber hinaus die Skalierbarkeit vereinfacht. Vorzugsweise ist eine Mehrzahl parallel geschalteter Kondensatoren, vorzugsweise eine Kondensatorbank vorgesehen, wobei die einzelnen Kondensatoren über die im ersten Rastermaß angeordneten Anschlusselemente mit der Gleichstromverschienung elektrisch leitend verbunden sind. Das erste Rastermaß der Gleichstromverschienung ermöglicht eine besonders kompakte Anordnung der Kondensatoren, da das Rastermaß beispielsweise auf die Größe und den Raumbedarf der Kondensatoren abgestimmt werden kann.

Bevorzugt sind die im zweiten Rastermaß angeordneten Anschlusselemente der Gleichstromverschienung derart ausgebildet, dass eine Mehrzahl an elektronischen Leistungsschaltern in achsensymmetrischer Anordnung mit der Gleichstromverschienung elektrisch leitend verbunden werden kann. Für die im zweiten Rastermaß angeordneten Anschlusselemente bedeutet dies, dass die elektrischen Anschlusspole beispielweise die Kontaktierung eines um 180 Grad gedrehten elektronischen Leistungsschalters ermöglicht. Die achsensymmetrische Anordnung von elektronischen Leistungsschaltern ermöglicht einen symmetrischen Aufbau der Schaltungsanordnung und insofern eine weitere Reduzierung des Raumbedarfs des Leistungsmoduls und somit des gesamten Leistungsschaltschranks.

Durch das Vorsehen einer Adapterverschienung, welche auf einer Anschlussseite an den elektronischen Leistungsschalter angepasst ist und auf der anderen Seite an das zweite Rastermaß angepasst ist, können elektronische Leistungsschalter unterschiedlicher Hersteller und/oder unterschiedlicher Typen eingesetzt werden.

Es können natürlich auch mehrere elektrisch miteinander verbundene Gleichstromverschienungen innerhalb eines Leistungsschaltschranks vorgesehen sein, um eine Skalierbarkeit innerhalb eines Leistungsschaltschranks zu erreichen. Diese können über kurze Kupferschienen, Kabel oder weitere Verschienungen seitlich in Reihe oder Rücken an Rücken verbunden werden.

Der Chopper kann entweder direkt mit der Gleichstromverschienung elektrisch verbunden sein oder über eine spezifische Adapterverschienung an die Gleichstromverschienung angeschlossen sein. Wird der Chopper direkt mit der Gleichstromverschienung verbunden, werden einerseits die Kosten für eine Adapterverschienung eingespart. Die Adapterverschienung kann aber dazu verwendet werden, um den Chopper anwendungsspezifisch an einer geeigneten Stelle der Schaltungsanordnung anzuordnen, ohne die Gleichstromverschienung verändern zu müssen.

Durch die direkte Anbindung des Choppers an die Gleichstromverschienung werden sehr geringe Streuinduktivitäten erreicht und eine gleichmäßige Aufteilung der Ströme durch die Gleichstromverschienung und der an der Gleichstromverschienung angeschlossenen Kondensatoren. Hierdurch wird eine gleichmäßige Wärmeverteilung erreicht, was wiederum einen kompakteren und besser zu kühlenden Leistungsschaltschrank ermöglicht. Vorzugsweise ist der Chopper zwischen den elektronischen Leistungsschaltern des netzseitigen Umrichters und des maschinenseitigen Umrichters auf einer Seite der Gleichstromverschienung angeordnet.

Gemäß einer weiteren Ausgestaltung der erfindungsgemäßen Schaltschrankanordnung, weisen die Leistungsschaltschränke jeweils einen dU/dt-Filter auf. Dieser ermöglicht eine Begrenzung von Spannungssteilheiten. Der dU/dt-Filter ist insbesondere dem maschinenseitigen Anschluss vorgeschaltet, also zwischen dem maschinenseitigen Umrichter und dem maschinenseitigen Anschluss angeordnet, und schützt die Maschine vor zu schnellen Spannungsänderungen. Indem die Leistungsschaltschränke einen dU/dt-Filter aufweisen, werden außerdem weitere Verkabelungen aus dem Leistungsschaltschrank heraus vermieden. Ein dU/dt-Filter weist insbesondere eine Drossel und optional eine RC-Beschaltung auf. Der dU/dt-Filter kann über Schienen, wie Kupferschienen, Kabel oder Litze eingebunden werden. Dadurch bleibt die Modularität der Komponenten erhalten und eine vereinfachte Wartung kann erreicht werden. Ein Sensor zur Überwachung der Temperatur des dU/dt-Filter kann optional mit der dezentralen Steuerungseinheit kommunizieren.

Vorzugsweise weisen die Leistungsschaltschränke netzseitig eine Netzdrossel auf. Diese dient der Entkopplung vom Netz, sodass Rückwirkungen ins Netz wie beispielsweise Oberschwingungsströme minimiert werden können. Die Netzdrossel kann ebenfalls über Schienen, wie Kupferschienen, Kabel oder Litze eingebunden werden. Dadurch bleibt die Modularität der Komponenten erhalten und eine vereinfachte Wartung kann erreicht werden. Insbesondere durch Litzenanschlüsse kann eine flexible Verbindung an einen Umrichter erreicht werden, was eine schnelle Montage oder auch die Verwendung von Netzdrosseln verschiedener Hersteller ermöglicht. Ein Sensor zur Überwachung der Temperatur der Netzdrossel kann auch mit der dezentralen Steuerungseinheit kommunizieren. Bei einer Anordnung der Komponenten in Reihe ist die Netzdrossel bevorzugt zwischen netzseitigem Anschluss und Leistungsmodul oder, falls eine Kühlvorrichtung vorhanden ist, zwischen netzseitigem Anschluss und dem der Kühlvorrichtung angeordnet. Besonders bevorzugt ist aufgrund von thermischen Effekten zur effektiveren Kühlung eine im Wesentlichen vertikale Anordnung, wobei die Netzdrossel unterhalb des Leistungsmoduls bzw. der Kühlvorrichtung angeordnet ist.

Es ist weiterhin bevorzugt, wenn die Leistungsschaltschränke an den netzseitigen Anschlüssen und/oder den maschinenseitigen Anschlüssen jeweils vorgeschaltete, also zwischen den netz- oder maschinenseitigen Umrichtern und den netz- oder maschinenseitigen Anschlüssen angeordnete, Trenneinrichtungen zum elektrischen Trennen der Leistungsschaltschränke, beispielsweise elektrische Trenneinrichtungen wie Schütze, IGBTs oder IGBCs oder auch mechanische Schalter aufweisen. Dies ermöglicht eine weitere Vereinfachung von Wartungsarbeiten, da auf diese Weise einzelne Leistungsschaltschränke netzseitig und/oder maschinenseitig vom Netz getrennt werden können. Die Schütze können beispielsweise über kurze Kupferverbindungen mit dem jeweiligen Anschluss elektrisch verbunden sein. Weist eine Schaltschrankanordnung beispielsweise zumindest teilweise redundante Leistungsschaltschränke auf, können diese selbst während des Betriebs ab- oder zugeschaltet werden. Eine Wartung oder ein Austausch von defekten Komponenten ist somit schnell und einfach durchzuführen. Zudem wird beispielsweise der Wirkungsgrad erhöht, wenn der Generator unterschiedliche Leistungen abgibt und bei geringeren Leistungen Leistungsschaltschränke abgeschaltet werden können. Des Weiteren kann bei einem Defekt in einem der Leistungsschaltschränke dieser elektrisch von den anderen getrennt werden. Somit kann das Gesamtsystem mit reduzierter Kapazität weiterbetrieben werden und Energie in das Netz einspeisen. Dies ist insbesondere für Offshore-Windenergieanlagen von Bedeutung, da diese nur unter erschwerten Bedingungen zu erreichen sind.

Gemäß einer weiteren Ausgestaltung der erfindungsgemäßen Schaltschrankanordnung weisen die Leistungsschaltschränke jeweils eine Kühlvorrichtung auf, insbesondere einen Wärmetauscher. Die Kühlung kann sowohl über Luftkühlung, beispielsweise mittels Lüfter, als auch über einen Wärmetauscher erfolgen. Der Wärmetauscher verwendet vorzugsweise ein Kühlmittel, insbesondere Wasser. Als Kühlmittel kann vorteilhaft auch ein Wasser-Glykol-Gemisch zum Einsatz kommen, es ist aber auch jedes andere flüssige Kühlmedium denkbar. Vorzugsweise werden aber beide Verfahren gleichzeitig genutzt, so dass ein entsprechend kompakter Aufbau realisiert werden kann. Komponenten, welche beispielsweise eine Wasserkühlung erlauben, dies sind im Allgemeinen die elektronischen Leistungsschalter der Wechselrichter und des Choppers, die dU/dt-Filter und die Netzdrossel, werden an einen Wasserkühlkreislauf angeschlossen. Bei anderen Komponenten wie beispielsweise den Zwischenkreiskondensatoren ist eine Luftkühlung vorteilhaft.

Vorzugsweise sind die Leistungsschaltschränke gemäß einer weiteren Ausgestaltung hermetisch gegenüber der Umgebungsluft abgeschlossen. Vorteilhaft ist in diesem Fall der Einsatz von Wärmetauschern, insbesondere ein Luft-Wasser-Wärmetauscher, welcher die Abwärme der Bauteile dem Wasserkühlkreislauf zuführt, so dass eine Zufuhr von kühlender Außenluft nicht notwendig ist. Durch die Verwendung von Wärmetauschern wird auch ohne Zuluft eine ausreichende Kühlung der Komponenten in den Leistungsschaltschränken sichergestellt. Die Kühlkreisläufe der Leistungsschaltschränke können zusammengeschaltet oder auch unabhängig voneinander betrieben werden. Aufgrund der unterschiedlichen Wärmeentwicklung der einzelnen Komponenten ist es besonders vorteilhaft, wenn die einzelnen Komponenten im Wesentlichen einer vertikalen Anordnung folgen. In diesem Fall kann entstehende Wärme durch die natürliche Konvektion abtransportiert werden. Die Kühlvorrichtung ist vorzugsweise unterhalb des Leistungsmoduls angeordnet, so dass die natürliche Konvektion unterstützt werden kann. Bei einem Wasser-Luft-Wärmetauscher wird hierbei eine optimale Kühlluftzirkulation erreicht, welche das Leistungsmodul, insbesondere die an einer Gleichstromverschienung angeordneten Kondensatoren, kühlen.

Eine Kühlung innerhalb eines Leistungsschaltschranks kann die Lebensdauer insbesondere in klimatisch ungünstigen Regionen der Komponenten erhöhen, da ein hermetischer Aufbau des Leistungsschaltschranks ermöglicht und eine Kontamination der Komponenten mit feuchter, salzhaltiger oder schmutziger Luft von außen vermieden wird. Bevorzugt werden das Leistungsmodul, also insbesondere der maschinenseitige und netzseitige Umrichter sowie der Chopper, die Netzdrossel und/oder der dU/dt-Filter wassergekühlt. Optional können auch an den netz- und maschinenseitig Anschlüssen vorgesehene Schütze luft- oder wassergekühlt werden.

In einer Wasserkühlung kann außerdem eine Vorheizeinrichtung vorgesehen sein, sodass bei sehr tiefen Umgebungstemperaturen das Leistungsmodul, insbesondere die elektronischen Leistungsschalter, einerseits auf Betriebstemperatur vorgewärmt werden kann und andererseits nach dem Betrieb Kondensation an diesen Komponenten vermieden werden kann.

Vorzugsweise sind die Leistungsschaltschränke mittels AC-Schienen parallel geschaltet. Hierdurch kann eine einfach zu montierende, und gleichzeitig stabile Parallelschaltung der einzelnen Leistungsschaltschränke realisiert werden. Die AC-Schienen sind aufgrund der Leitfähigkeit vorzugsweise aus Kupfer. Im Falle von Dreiphasenwechselstrom sind mindestens dreipolige Schienen vorzusehen. Die AC-Schienen können so angeordnet werden, dass die Verbindung zu anderen Leistungsschaltschränken seitlich, rückwärtig und/oder nach oben möglich ist. Die Vorderseite der Leistungsschaltschränke dient vorzugsweise für einen einfachen Montage- und Wartungszugriff.

Grundsätzlich sind aber auch Kabel und/oder Litzen zur Verbindung der Leistungsschaltschränke denkbar.

Gemäß einer weiteren Ausgestaltung der erfindungsgemäßen Schaltschrankanordnung sind die Leistungsschaltschränke seitlich in Reihe und/oder Rücken an Rücken angeordnet. Auf diese Weise kann eine einfache Leistungsanpassung trotz einer kompakten Anordnung der Leistungsschaltschränke erzielt werden.

Gemäß einer bevorzugten Ausgestaltung der erfindungsgemäßen Schaltschrankanordnung weist die Schaltschrankanordnung einen Netzanschlussschaltschrank auf, welcher eine zentrale Steuerungseinheit aufweist. Über die zentrale Steuerungseinheit können die dezentralen Steuerungseinheiten der Leistungsschaltschränke gesteuert werden. Wird eine Verbindung zwischen den dezentralen Steuerungseinheiten und der zentralen Steuerungseinheit hergestellt, kann über die Verbindung auf einfache Weise jede Komponente der Leistungsschaltschränke angesprochen werden. Soll beispielsweise die Schaltschrankanordnung um einen weiteren Leistungsschaltschrank erweitert werden, muss lediglich der netzseitige und maschinenseitige Anschluss elektrisch verbunden werden und die dezentrale Steuerungseinheit sowie die Hilfsspannungsversorgung angeschlossen werden. Die Anzahl der nötigen Verbindungen und Verkabelungen wird also auf ein Minimum reduziert. Hierbei keine sowohl eine Stern, Ring-, Reihen- und/oder Bustopologie der dezentralen Steuerungseinheiten vorgesehen sein. Die Verwendung eines separaten Netzanschlussschaltschrankes verbessert zudem die Skalierbarkeit der Schaltschrankanordnung, da dieser bei Leistungsanpassungen ausgetauscht bzw. getrennt von den Leistungsschaltschränken angepasst werden kann.

Die zentrale Steuerungseinheit kann aber auch so ausgebildet sein, dass sie mit weiteren Systemen kommunizieren kann. So können verschiedene Schnittstellen und Busse, wie Ethernet, CANOpen oder andere digitale oder analoge Ein- und Ausgänge vorgesehen sein, um beispielsweise Daten des Generators oder des Rotors ebenfalls berücksichtigen oder beeinflussen zu können.

Der Netzanschlussschrank dient des Weiteren der Verbindung der Leistungsschaltschränke mit dem Netz.

Vorzugsweise weist der Netzanschlussschaltschrank einen oder mehrere Netzfilter auf. Dieser dient einer Begrenzung von elektrischen Störungen sowohl in das Netz als auch aus dem Netz. Ein solcher Netzfilter kann aus Induktivitäten, Kondensatoren und/oder Widerständen aufgebaut sein. Dadurch, dass der Netzfilter in dem Netzanschlussschrank vorgesehen ist, ist er allen Leistungsschaltschränken vorgeschaltet und es muss nur ein einziger Filter vorgesehen werden. Es ist grundsätzlich aber auch denkbar, Netzfilter jeweils in die Leistungsschaltschränke zu integrieren.

Der Netzanschlussschaltschrank weist bevorzugt eine Hilfsspannungsversorgung und/oder einen Netzschalter auf. Die Hilfsspannungsversorgung erzeugt aus dem netzseitigen Wechselstrom vorzugsweise eine einphasige 230 V Wechselspannung. Es sind jedoch beliebige Gleich- und/oder Wechselspannungen denkbar. Ebenso ist es möglich, die Hilfsspannung von extern einzuspeisen, so dass in diesem Fall die Hilfsspannungsversorgung im Netzanschlussschrank lediglich als Verteilknoten für die Leistungsschaltschränke dient. Die Hilfsspannungsversorgung kann so auf einfache Weise für alle Leistungsschaltschränke bereitgestellt werden. Über einen oder mehrere Netzschalter können alle Leistungsschaltschränke auf einfach Weise vom Netz getrennt werden.

Vorzugsweise sind die zentrale Steuerungseinheit und die dezentralen Steuerungseinheiten so ausgebildet, dass die zentrale Steuerungseinheit und die dezentralen Steuerungseinheiten über Lichtwellenleiter miteinander verbindbar sind. Auf diese Weise werden die nötigen Kabelverbindungen reduziert, was die Installation und die Skalierbarkeit zusätzlich vereinfacht. Bei der Verwendung von Lichtwellenleitern werden Signalstörungen aufgrund von möglichen hochfrequenten Störimpulsen vermieden.

Die oben hergeleitet Aufgabe wird insbesondere durch eine Vorrichtung zur Erzeugung elektrischer Energie, welche eine erfindungsgemäße Schaltschrankanordnung aufweist, gelöst. Wie bereits ausgeführt, lässt sich durch eine erfindungsgemäße Schaltschrankanordnung ein kostensparender, kompakter Aufbau mit minimalen Verbindungsstrecken zwischen den Komponenten und dadurch mit einem optimaler Leistungsfluss und hoher Leistungsdichte realisieren.

Dies gilt insbesondere für eine weiter ausgestaltete erfindungsgemäße Vorrichtung zur Erzeugung elektrischer Energie, welche als Windenergieanlage mit einem Generator ausgebildet ist und eine erfindungsgemäße Schaltschrankanordnung aufweist. Als Generatoren werden wie eingangs erwähnt beispielsweise doppelt gespeiste Asynchronmaschinen oder Synchronmaschinen verwendet. Da Windenergieanlagen je nach Größe oder Windstärke am Einsatzort unterschiedlichste Leistungen erzeugen, müssen die verwendeten Komponenten und insbesondere die Umrichter entsprechend dieser Leistung angepasst werden können. Dies gelingt mit der erfindungsgemäßen Schaltschrankanordnung besonders einfach und kostengünstig. Ferner ist der zu Verfügung stehende Raum bei Windenergieanlagen - beispielsweise im Inneren eines Turmes einer Winkkraftanlage - meistens begrenzt, sodass der kompakte Aufbau der Leistungsschaltschränke und damit auch der gesamten Schaltschrankanordnung vorteilhaft ist. Insbesondere beim Einsatz von Synchronmaschinen mit Vollumrichtern wird die gesamte elektrische Leistung über die Umrichter geführt, sodass ein kompakter und skalierbarer Aufbau bei gleichzeitig optimaler Kühlung von Vorteil ist. Einen minimalen Raumbedarf ermöglicht beispielsweise eine Rücken an Rücken Anordnung der Leistungsschaltschränke, ohne die Zugänglichkeit und damit die Wartungsfreundlichkeit zu verschlechtern.

Im Weiteren wird die Erfindung anhand der Beschreibung von Ausführungsbeispielen in Verbindung mit der Zeichnung näher erläutert. In der Zeichnung zeigt
- Fig. 1: schematisch in Form eines Schaltplans den Aufbau eines Ausführungsbeispiels eines Leistungsschaltschranks,
- Fig. 2: schematisch in Form eines Blockdiagramms die Anordnung der Komponenten eines weiteren Ausführungsbeispiels eines Leistungsschaltschranks,
- Fig. 3: in einer perspektivischen Darstellung ein Ausführungsbeispiel eines Leistungsmoduls mit Chopper,
- Fig. 4: in einer perspektivischen Darstellung ein weiteres Ausführungsbeispiel eines Leistungsmoduls,
- Fig. 5: schematisch in Form eines Schaltplans den Aufbau eines Ausführungsbeispiels einer Schaltschrankanordnung einer Windenergieanlage,
- Fig. 6: in einer perspektivischen Darstellung ein weiteres Ausführungsbeispiel eines Leistungsschaltschranks,
- Fig. 7: verschiedene Ausführungsbeispiele einer Schaltschrankanordnung und
- Fig. 8: eine schematische Darstellung ein Ausführungsbeispiel einer Windenergieanlage mit einer Schaltschrankanordnung

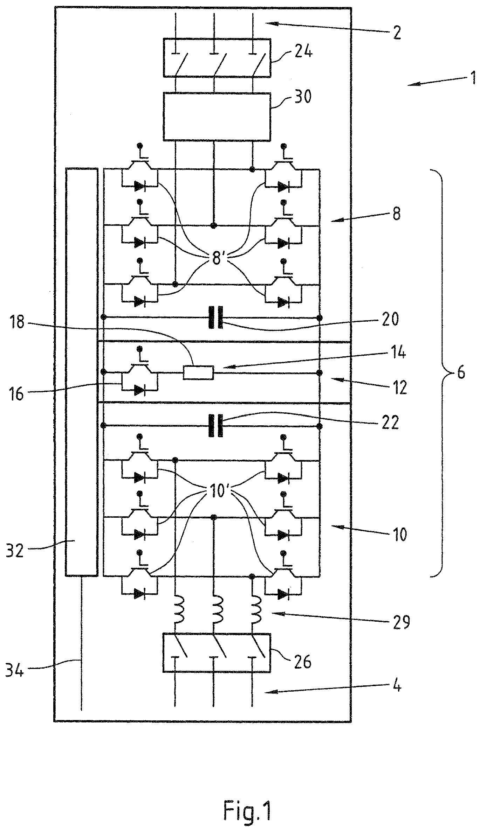

Fig. 1 zeigt schematisch in Form eines Schaltplans den Aufbau eines Ausführungsbeispiels eines Leistungsschaltschranks 1.

Wie dem Schaltplan zu entnehmen ist, weist der Leistungsschaltschrank 1 an einem ersten Ende einen maschinenseitigen Anschluss 2 und an einem zweiten Ende einen netzseitigen Anschluss 4 auf. In diesem Ausführungsbeispiel sind beide Anschlüsse 2, 4 mit drei Leitern zur Bereitstellung von dreiphasigem Strom ausgelegt. Diese Anschlüsse 2, 4 können mit Kabeln oder AC-Schienen, vorzugsweise Kupferschienen, realisiert werden. Über den maschinenseitigen Anschluss 2 können mehrere Schaltschränke 1 parallel geschaltet werden und mit einen Generator 68, beispielsweise einer permanenterregten Synchronmaschine, elektrisch leitend verbunden werden. Über den netzseitigen Anschluss 4 wird der Leistungsschaltschrank 1 elektrisch leitend mit dem Netz, beispielsweise einem Stromversorgungsnetz elektrisch verbunden. Vorzugsweise sind die mindestens zwei Leistungsschränke über die netzseitigen Anschlüsse 4 parallel geschaltet. Dabei können auch noch weitere Komponenten, wie Schalter oder Filter, insbesondere ein Netzanschlussschaltschrank 72, zwischen Netz und netzseitigem Anschluss 2 geschaltet werden.

Zwischen den Anschlüssen 2, 4 ist ein Leistungsmodul 6 angeordnet. Dieses weist einen maschinenseitigen Umrichter 8, einen netzseitigen Umrichter 10, einen Gleichspannungszwischenkreis 12 und einen Chopper 14 auf. Der Chopper 14 besteht aus einem elektronischen Leistungsschalter 16 und einem Bremswiderstand 18. Der elektronische Leistungsschalter 16 ist in diesem Fall ein IGBT. Die Umrichter 8, 10 weisen mehrere elektronische Leistungsschalter in Form von IGBTs 8', 10' auf. Es können aber auch andere elektronische Leistungsschalter verwendet werden. Der Gleichspannungszwischenkreis 12 ist über zwei Kondensatoren 20, 22 angedeutet, welche üblicherweise als Kondensatorbank 48 aus einer Vielzahl von parallel geschalteten Kondensatoren bestehen.

Der Leistungsschaltschrank 1 weist weiterhin vorzugsweise zwei Schütze 24, 26 auf, welche den Anschlüssen 2, 4 vorgeschaltet sind. Mithilfe der Schütze 24, 26 kann der gesamte Schaltschrank 1 als Einheit sowohl vom Netz als auch vom Generator 68 getrennt werden. Dies ist insbesondere für Wartungs- und Reparaturzwecke, Installationen oder bei Defekten vorteilhaft. Die Netzdrossel 29 dient der Entkopplung von Umrichter und Netz.

Zur Vermeidung von Spannungssteilheiten insbesondere am Generator ist zwischen dem maschinenseitigen Umrichter 8 und dem Schütz 24 vorzugsweise ein dU/dt-Filter 30 angeordnet.

Der Leistungsschaltschrank 1 weist des Weiteren eine dezentrale Steuerungseinheit 32 auf. Diese kann mit beliebigen Komponenten des Leistungsschaltschranks 1 kommunizieren, jedoch bevorzugt mit allen Aktoren und Sensoren im Leistungsschaltschrank, beispielsweise mit den Umrichtern 8, 10 dem Chopper 14 und/oder den Schützen 24, 26. Auf diese Weise bildet der Leistungsschaltschrank 1 im Wesentlichen eine Einheit, sodass eine Schaltschrankanordnung 64, 96, 98 einfach an die Leistung eines Generators 68 durch Vorsehen einer entsprechenden Anzahl an Leistungsschaltschränken 1 angepasst werden kann. Die dezentrale Steuerungseinheit wird hier über einen, oder typischerweise zwei, Lichtwellenleiter 34 mit weiteren Steuerungseinheiten verbunden. Jedoch sind auch andere Übertragungstechniken mittels Netzwerkkabeln oder auch kabellose Übertragungsmethoden denkbar. Die dezentrale Steuerungseinheit 32 ermöglicht vor allem die Realisierung kurzer Signalwege innerhalb des Leistungsschaltschrankes selbst, so dass hier einfache elektrische Verbindungen trotz der starken elektromagnetischen Störfelder möglich werden. In jedem Fall reduziert sich die benötigte Anzahl von Kabelverbindungen zu einer zentralen Steuereinrichtung durch das Vorsehen einer dezentralen Steuerungseinheit 32 auf ein Minimum.

Grundsätzlich wird die reale Positionierung der Komponenten in einem Leistungsschaltschrank 1 nicht durch die Anordnung der Komponenten eines Schaltplans festgelegt. Es ist jedoch vorteilhaft, wenn die Komponenten im Wesentlichen in der gleichen Reihenfolge wie im Schaltplan angeordnet sind.

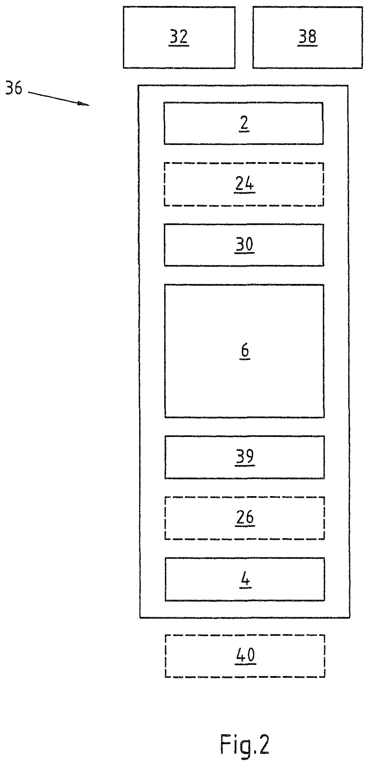

Fig. 2 zeigt schematisch in Form eines Blockdiagramms die Anordnung der Komponenten eines weiteren Ausführungsbeispiels eines Leistungsschaltschranks 36. Vor allem durch die Anordnung der Komponenten im Wesentlichen in einer Reihe mit der Reihenfolge: maschinenseitiger Anschluss 2, optional maschinenseitiges Schütz 24, dU/dt-Filter 30, Leistungsmodul 6, Netzdrossel 39, optional netzseitiges Schütz 26 und netzseitiger Anschluss 2 ist besonders vorteilhaft in Bezug auf eine kompakte Anordnung der Komponenten bei gleichzeitig einfacher Zugänglichkeit der einzelnen Komponenten und der Möglichkeit einer ausreichenden und effektiven Kühlung. Die Anordnung kann selbstverständlich auch in umgekehrter Reihenfolge erfolgen. Eine wie gezeigt vertikale Anordnung der Komponenten in dem Leistungsschaltschrank 36 ist aufgrund der einfachen Zugänglichkeit und thermischen Effekten beim Kühlen bevorzugt. Hier kann die natürliche Konvektion die Kühlung unterstützen. Eine dezentrale Steuerungseinheit 32 sowie eine Zwischenkreisvorladeeinheit können hierbei flexibel im Leistungsschaltschrank 36 positioniert werden. Auch eine Kühlvorrichtung 38 erstreckt sich in der Regel über mehrere Komponenten im Leistungsschaltschrank 36. Es ist jedoch vorteilhaft eine Kühlung in Form eines Luft-Wasser-Wärmetauschers zwischen dem Leistungsmodul 6 und der Netzdrossel 39 vorzusehen. Vorzugsweise durch Konvektion können mittels Wasser und Luft die einzelnen Komponenten gekühlt werden. Auch ein Netzfilter 40 kann optional in dem Leistungsschaltschrank 36 vorgesehen sein.

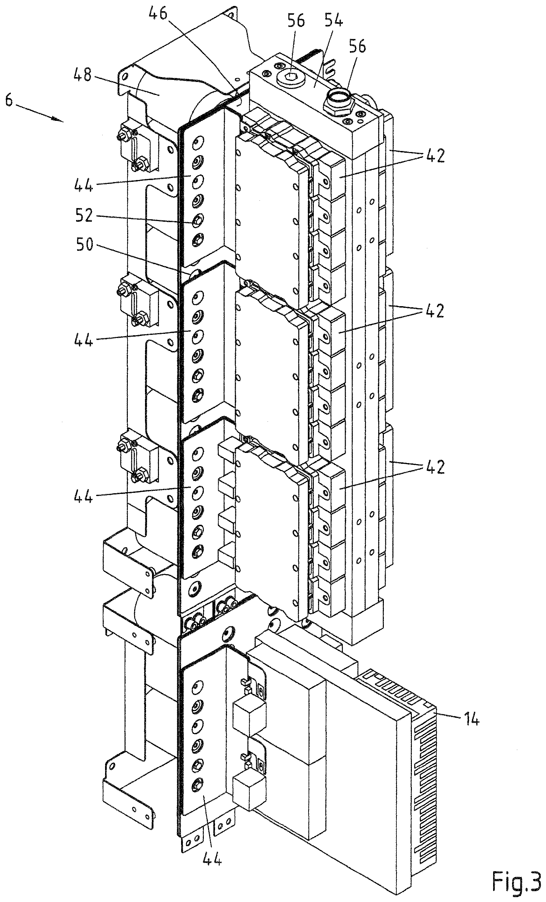

Fig. 3 zeigt nun in einer perspektivischen Darstellung ein Ausführungsbeispiel eines Leistungsmoduls 6 mit Chopper 14. Mehrere elektronische Leistungsschalter 42 in Form von IGBTs sind mittels Adapterverschienungen 44 an eine Gleichstromverschienung 46 angeschlossen. Die elektronischen Leistungsschalter 42 sind alle auf einer Seite der Gleichstromverschienung 46 angeordnet. Auf der gegenüberliegenden Seite der Gleichstromverschienung 46 ist eine Kondensatorbank 48 angeordnet. Es ist des Weiteren erkennbar, wie die Kondensatorbank 48 über ein erstes Rastermaß (nicht dargestellt) und die elektronischen Leistungsschalter 42 mit der Adapterverschienung 44 über ein zweites Rastermaß 52 mit der Gleichstromverschienung 46 elektrisch verbunden sind. Vorzugsweise werden rechtwinklige Adapterverschienungen 44 verwendet, um eine Positionierung der Leistungsschalter bzw. des Choppers außerhalb der Ebene der Gleichstromverschienung zu erreichen. Diese Anordnung der Leistungsschalter gewährleistet eine verbesserte Kühlung der Leistungsschalter oder auch des Choppers.

An die Gleichstromverschienung 46 ist des Weiteren auch ein Chopper 14 angeschlossen. Der Chopper 14 dient dazu, die Kondensatorbank 48 sowie die elektronischen Leistungsschalter 42 vor Überspannungen zu schützen. Die Kombination der elektronischen Leistungsschalter 42 mit einem zusätzlich auf der Gleichstromverschienung 46 angeordneten Chopper 14 erlaubt die direkte Anbindung des Choppers 14 an die Kondensatorbank 48. Es wird somit auf eine Kabelverbindung zwischen der Gleichstromverschienung 46 und dem Chopper 14 verzichtet. Da die Zwischenkreisspannung regelmäßig über 1000 V liegt, ist dies sowohl aus sicherheitstechnischen Aspekten als auch im Hinblick auf die elektromagnetische Verträglichkeit des Leistungsmoduls 6 vorteilhaft. Des Weiteren ergibt sich eine Reduzierung des Platzbedarfs.

Das Leistungsmodul 6 aus Fig. 3 weist weiterhin einen Kühlkörper 54 mit Kühlmittelanschlüssen 56 auf. Durch die Anordnung eines Kühlkörpers 54 zwischen den elektronischen Leistungsschaltern 42 können diese mit einem einzigen Kühlkörper 54 effektiv gekühlt und kompakt angeordnet werden.

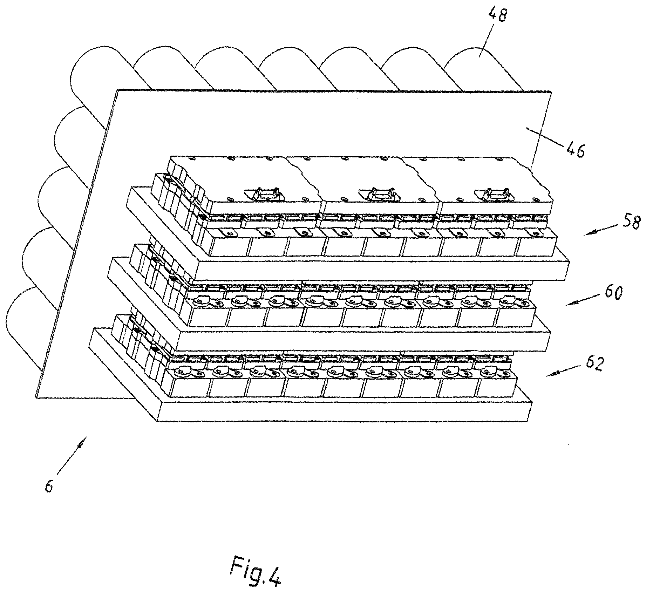

Fig. 4 zeigt in einer perspektivischen Darstellung ein weiteres Ausführungsbeispiel eines Leistungsmoduls 6. Die elektronischen Leistungsschalter 42 sind in drei Baugruppen 58, 60, 62 zusammengefasst und auf der Gleichstromverschienung 46 angeordnet. Jede dieser Baugruppen verfügt über einen Kühlkörper, vorzugsweise für Wasserkühlung. Auf der gegenüberliegenden Seite ist wiederum die Kondensatorbank 48 angeordnet. Es ist besonders bevorzugt, wenn die Baugruppen 58, 62 die elektronischen Leistungsschalter 8', 10' der Umrichter 8, 10 aufweisen, während die mittlere Baugruppe 60 den oder die elektronischen Leistungsschalter des Choppers 14 sowie optional den Widerstand 18 aufweisen. Wie leicht zu erkennen ist, können einzelne Baueinheiten 58, 60, 62 auf einfache Weise ersetzt werden, sofern diese beispielsweise defekt sind. Darüber hinaus ist eine Skalierbarkeit sehr einfach durch Hinzufügen oder Entfernen von weiteren Baueinheiten 58, 60, 62 möglich.

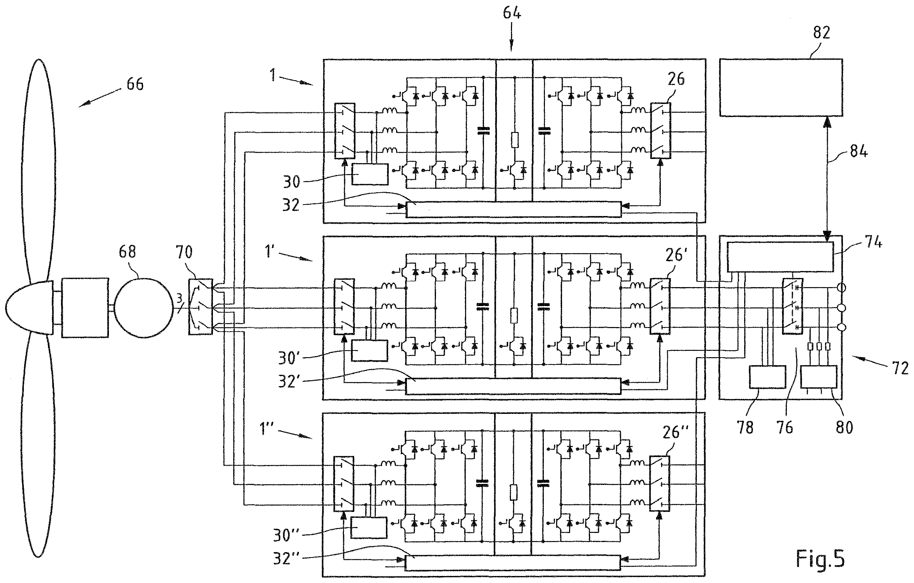

Fig. 5 zeigt schematisch in Form eines Schaltplans den Aufbau eines Ausführungsbeispiels einer Schaltschrankanordnung 64. Diese weist den Leistungsschaltschrank 1 aus Fig. 1 und zwei weitere vorzugsweise baugleiche Leistungsschaltschränke 1', 1'' auf. Die Leistungsschaltschränke 1, 1', 1'' sind parallel geschaltet. Es ist auch denkbar, Leistungsschaltschränke 1, 1', 1'' mit unterschiedlicher Auslegung in einer Schaltschrankanordnung 64 vorzusehen, um gegebenenfalls eine bessere Leistungsanpassung zu erzielen. Auch ist natürlich denkbar, nur zwei oder mehr als drei Leistungsschaltschränke vorzusehen. Durch einen Rotor 66 wird ein permanentmagneterregter Synchrongenerator 68 angetrieben. Dieser ist über einen Generatorschalter 70, welcher optional in einem Generatoranschlussschrank (nicht dargestellt) vorgesehen sein kann, mit den Leistungsschaltschränken 1, 1', 1'' elektrisch leitend verbunden.

Netzseitig sind die Leistungsschaltschränke 1, 1', 1'' mit einem Netzanschlussschaltschrank 72 elektrisch verbunden. Dieser weist eine zentrale Steuerungseinheit 74, einen Netzschalter 76, einen Netzfilter 78 und eine Hilfsspannungsversorgung 80 auf. Der Netzfilter 78 ist auf diese Weise allen Leistungsschaltschränke 1, 1', 1'' vorgeschaltet und muss nicht separat in jeden Leistungsschaltschrank implementiert werden. Jedoch ist es möglich, den Netzfilter 78 in den Leistungsschaltschränken 1, 1', 1'' vorzusehen. Der Netzschalter 76, um schnell und einfach die Leistungsschaltschränke 1, 1', 1'' vom Netz zu trennen, kann beispielsweise auch ein elektronischer Leistungsschalter sein. Es ist gut zu erkennen, dass abgesehen von den leitenden Verbindungen der netzseitigen Anschlüsse 26, 26', 26" mit dem Netzanschlussschaltschrank 72 lediglich eine Verbindung der dezentralen Steuerungseinheiten 32, 32', 32" mit der zentralen Steuerungseinheit 74 sowie eine Verbindung der Hilfsspannungsversorgungseinheit 80 mit den Leistungsschaltschränken 1, 1', 1'' erforderlich ist. Auf diese Weise wird ein geringer Installationsaufwand und optimale Skalierbarkeit der Schaltschrankanordnung 64 erreicht. Die zentrale Steuerung 72 ist in diesem Ausführungsbeispiel mit einer Windenergieanlagensteuerung 82 über eine Datenverbindung 84 verbunden. Die Windenergieanlagensteuerung 82 kann beispielsweise Daten über den Generator 68 oder den Rotor 66 zur Verfügung stellen oder diese beeinflussen oder Leistungs- oder Stromsollwerte vorgeben. Als Datenverbindung 84 können verschiedene Schnittstellen und Busse, wie Ethernet, CANOpen oder andere digitale oder analoge Ein- und Ausgänge vorgesehen sein.

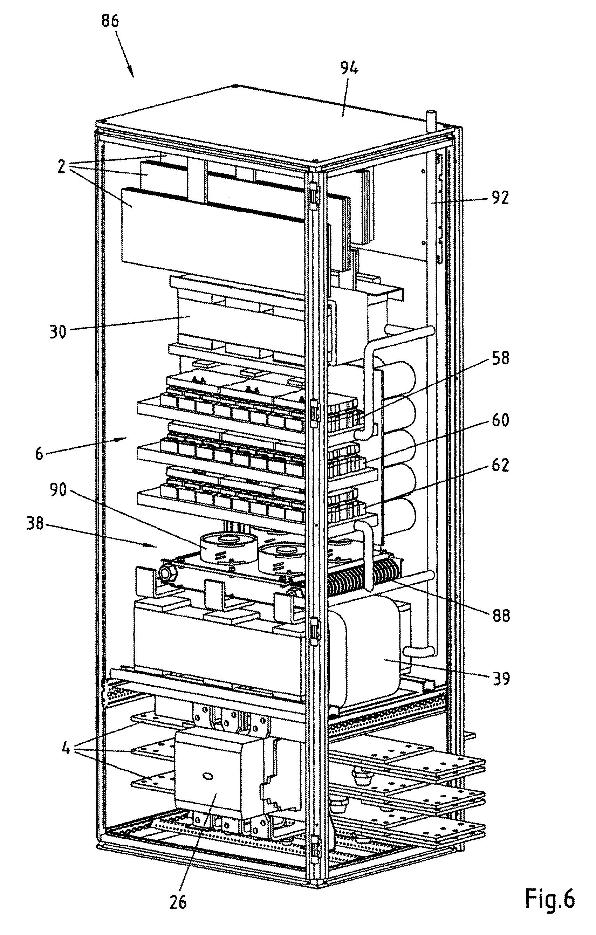

Fig. 6 zeigt in einer perspektivischen Darstellung ein weiteres Ausführungsbeispiel eines Leistungsschaltschranks 86. Der Leistungsschaltschrank 86 weist als netz- und maschinenseitige Anschlüsse 2, 4 AC-Schienen auf. Diese sind für dreiphasigen Wechselstrom ausgelegt. Die AC-Schienen für den netzseitigen Anschluss 4 sind horizontal übereinander angeordnet, während die AC-Schienen für den maschinenseitigen Anschluss 2 vertikal hintereinander angeordnet sind. Jedoch sind andere Anordnungen ebenfalls denkbar. Ein Schütz 26 ist im Bereich des netzseitigen Anschlusses 4 angeordnet.

Oberhalb des netzseitigen Anschlusses 4 ist eine Netzdrossel 39 in den Leistungsschaltschrank 86 integriert. Hierüber ist eine Kühlvorrichtung 38 eingebaut, welche einen Luft-Wasser-Wärmetauscher 88 und einen Lüfter 90 aufweist. Insbesondere durch den Wasserkühlkreislauf 92 kann die Netzdrossel 39 gekühlt werden.

Oberhalb des Lüfters 90 ist das Leistungsmodul 6 aus Fig. 4 angeordnet. Jedoch können auch andere Ausführungsformen des Leistungsmoduls hier angeordnet sein. Durch diese Anordnung kann insbesondere die Kondensatorbank 48 des Leistungsmoduls 6 effektiv durch den Lüfter 90 gekühlt werden. Die Baugruppen 58, 60, 62 werden hierbei durch den Wasserkühlkreislauf 92 gekühlt, bzw. vor Inbetriebnahme auch optional erwärmt, um sie auf Betriebstemperatur zu bringen.

Oberhalb des Leistungsmoduls 6 ist der dU/dt-Filter 30 angeordnet, welcher ebenfalls durch die Kühlvorrichtung 38 gekühlt wird.

Schließlich ist oberhalb des dU/dt-Filters 30 der maschinenseitige Anschluss 2 in Form von AC-Schienen angeordnet.

Es ist gut ersichtlich, wie die einzelnen Komponenten im Leistungsschaltschrank 86 in den Rahmen 94 im Wesentlichen in einer Reihe in einer vertikalen Anordnung angeordnet sind. Eine im Wesentlichen horizontale Anordnung oder eine Anordnung in umgekehrter Reihenfolge ist natürlich auch denkbar. Durch die Anordnung in gegebener Reihenfolge, welche im Wesentlichen der Richtung des Leistungsflusses entspricht, können die Komponenten im Leistungsschaltschrank 86 sehr kompakt und gut zugängliche angeordnet werden, während sie gleichzeitig ausreichend gekühlt werden können.

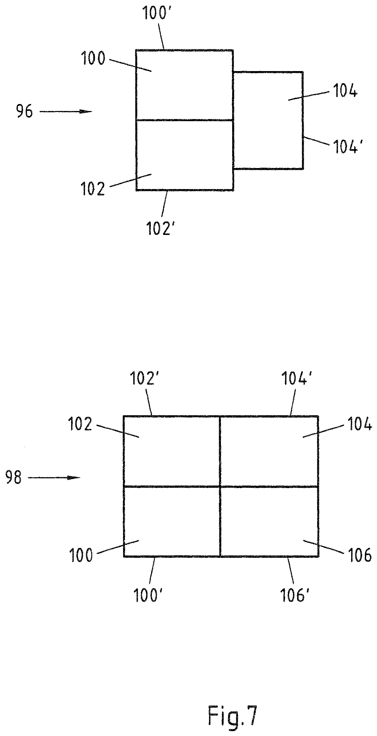

Fig. 7 zeigt verschieden Ausführungsformen einer erfindungsgemäßen Schaltschrankanordnung 96, 98. Die Schaltschrankanordnung 96 zeigt drei Schaltschränke 100, 102, 104 von oben. Hierbei sind die Schaltschränke 100, 102 Rücken an Rücken angeordnet, während der Schaltschrank 104 seitlich quer zu den Schaltschränken 100, 102 angeordnet ist. Die Schaltschränke 100, 102, 104 sind insbesondere Leistungsschaltschränke, wobei vorzugsweise einer der Schaltschränke 100, 102, 104 auch ein Netzanschlussschaltschrank ist. Besonders vorteilhaft bei dieser Anordnung ist es, dass die AC-Schienen in den Leistungsschaltschränken 100 und 102 nur für den jeweiligen Bemessungsstrom ausgelegt sein müssen. Erst im Netzanschlussschaltschrank 104 werden die AC-Schienen zum Anschluss an das Netz zusammengeführt, so dass nur in diesem Schaltschrank die AC-Schienen für die Summe der Bemessungsströme der beiden Schaltschränke 100 und 102 ausgelegt sein müssen. Hierdurch lassen sich Kosten für Kupferverbindungen einsparen.

Die Schaltschrankanordnung 98 zeigt nun vier Schaltschränke 100, 102, 104, 106 von oben. Die Schaltschränke 100, 106 und 102, 104 sind jeweils seitlich nebeneinander angeordnet, während die Schaltschränke 100, 102 und 106, 104 jeweils Rücken an Rücken angeordnet sind. Die Schaltschränke 100, 102, 104, 106 sind insbesondere Leistungsschaltschränke, wobei vorzugsweise einer der Schaltschränke 100, 102, 104, 106 auch ein Netzanschlussschaltschrank ist.

Natürlich sind auch andere geometrische Anordnung der Schaltschränke denkbar, insbesondere seitliche Anordnungen in Reihe oder Anordnungen übereinander oder Anordnungen mit weniger als drei oder mehr als 4 Schaltschränken.

Es ist deutlich erkennbar, dass durch die Schaltschrankanordnungen 96, 98 eine platzsparende Anordnung möglich ist, wobei gleichzeitig ein einfacher Zugriff auf die Komponenten jedes Schaltschranks über die Vorderseiten 100', 102', 104', 106' möglich ist. Für die entsprechenden Anordnungen müssen lediglich die netzseitigen und maschinenseitigen Anschlüsse 2, 4 so angeordnet sein, dass die entsprechende Anordnung möglich ist.

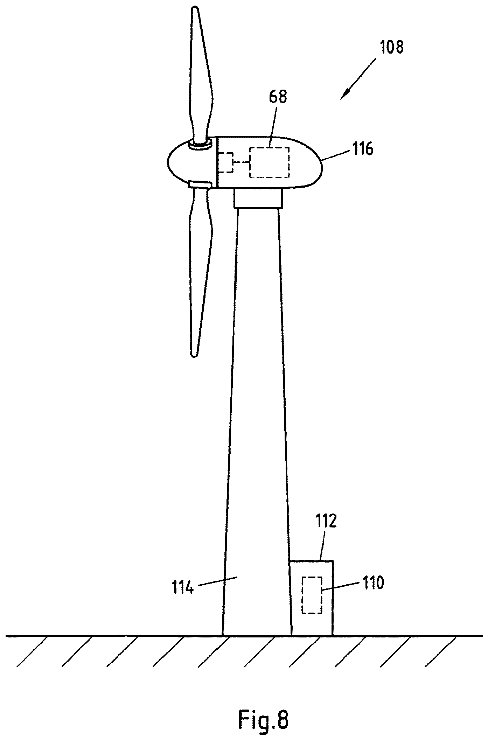

Fig. 8 zeigt nun eine schematische Darstellung einer Windenergieanlage 108 mit einer erfindungsgemäßen Schaltschrankanordnung 110. Diese kann beispielsweise so ausgebildet sein, wie die Schaltschrankanordnungen 64, 96 oder 98. Die Schaltschrankanordnung 110 ist ein einem Gehäuse 112 am Fuß der Windenergieanlage 108 montiert. Die Schaltschrankanordnung 110 kann aber auch innerhalb des Turms 114 oder in der Nähe des Generators 68, also beispielsweise in der Gondel 116 der Windenergieanlage 108, angeordnet sein. Aufgrund des geringen Platzangebots in Windenergieanlagen, insbesondere in der Gondel 116 und im Turm 114 sowie der notwendigen Anpassung der Windenergieanlagen 108 an unterschiedliche Leistungsbereiche ist die Verwendung der erfindungsgemäßen Schaltschrankanordnung 110 für Windenergieanlagen 108 besonders vorteilhaft.

## Patentansprüche

1. Schaltschrankanordnung einer Vorrichtung zur Erzeugung elektrischer Energie, wobei die Schaltschrankanordnung (64, 96, 98) mindestens zwei separate Leistungsschaltschränke (1, 1', 1", 36, 86) aufweist, **dadurch gekennzeichnet, dass**
die Leistungsschaltschränke (1, 1', 1", 36, 86) jeweils
- einen maschinenseitigen Anschluss (2),
- ein Leistungsmodul (6),
- einen netzseitigen Anschluss (4) und
- eine dezentrale Steuerungseinheit (32, 32', 32")
aufweisen, wobei das Leistungsmodul (6)
- einen maschinenseitigen Umrichter (8),
- einen netzseitigen Umrichter (10),
- einen Gleichspannungszwischenkreis (12) und
- einen Chopper (14)
aufweist und wobei die Leistungsschaltschränke (1, 1', 1", 36, 86) über den netzseitigen Anschluss (2) und optional über den maschinenseitigen Anschluss (4) elektrisch parallel miteinander verbunden sind,
**dadurch gekennzeichnet, dass**
das Leistungsmodul (6) eine plattenförmige Gleichstromverschienung (46) aufweist, welche auf einer ersten Seite die Leistungsschalter und einen Chopper (8', 10', 12, 42, 58, 60, 62) aufweist und auf einer zweiten Seite die Kondensatoren des Gleichspannungszwischenkreises (20, 22, 48) aufweist.

2. Schaltschrankanordnung nach Anspruch 1,
**dadurch gekennzeichnet, dass**
alternativ die Leistungsschaltschränke (1, 1', 1", 36, 86) jeweils einzeln über zugeordnete Sekundärwicklungen eines oder mehrerer Transformatoren an das Netz angebunden sind.

3. Schaltschrankanordnung nach einem der Ansprüche 1 bis 2, **dadurch gekennzeichnet, dass**
die Leistungsschaltschränke (1, 1', 1", 36, 86) jeweils einen dU/dt-Filter (30, 30', 30") aufweisen.

4. Schaltschrankanordnung nach einem der Ansprüche 1 bis 3, **dadurch gekennzeichnet, dass**
die Leistungsschaltschränke (1, 1', 1", 36, 86) netzseitig eine Netzdrossel aufweisen.

5. Schaltschrankanordnung nach einem der Ansprüche 1 bis 4, **dadurch gekennzeichnet, dass**
die Leistungsschaltschränke (1, 1', 1", 36, 86) an den netzseitigen Anschlüssen (4) und/oder den maschinenseitigen Anschlüssen (2) jeweils vorgeschaltete Einrichtungen zum elektrischen Trennen der Leistungsschaltschränke (24, 26, 26', 26") aufweisen.

6. Schaltschrankanordnung nach einem der Ansprüche 1 bis 5, **dadurch gekennzeichnet, dass**
die Leistungsschaltschränke (1, 1', 1", 36, 86) jeweils eine Kühlvorrichtung (38) , insbesondere einen Wärmetauscher (88) aufweisen.

7. Schaltschrankanordnung nach einem der Ansprüche 1 bis 6, **dadurch gekennzeichnet, dass**
die Leistungsschaltschränke (1, 1', 1", 36, 86) gegenüber der Umgebungsluft hermetisch geschlossen sind.

8. Schaltschrankanordnung nach einem der Ansprüche 1 bis 7, **dadurch gekennzeichnet, dass**
die Leistungsschaltschränke (1, 1', 1", 36, 86) mittels AC-Schienen elektrisch parallel geschaltet sind.

9. Schaltschrankanordnung nach einem der Ansprüche 1 bis 8, **dadurch gekennzeichnet, dass**
die Leistungsschaltschränke (1, 1', 1", 36, 86) seitlich in Reihe und/oder Rücken an Rücken angeordnet sind.

10. Schaltschrankanordnung nach einem der Ansprüche 1 bis 9, **dadurch gekennzeichnet, dass**
die Schaltschrankanordnung (64, 96, 98) einen separaten Netzanschlussschaltschrank (72) aufweist, welcher eine zentrale Steuerungseinheit (74) aufweist.

11. Schaltschrankanordnung nach Anspruch 10,
**dadurch gekennzeichnet, dass**
der Netzanschlussschaltschrank (72) mindestens einen Netzfilter (78) aufweist.

12. Schaltschrankanordnung nach Anspruch 10 oder 11,
**dadurch gekennzeichnet, dass**
der Netzanschlussschaltschrank (72) eine Hilfsspannungsversorgung (80) und/oder einen Netzschalter (76) aufweist.

13. Schaltschrankanordnung nach einem der Ansprüche 1 bis 12,
**dadurch gekennzeichnet, dass**
eine zentrale Steuerungseinheit (74) und dezentrale Steuerungseinheiten (32, 32', 32") vorgesehen sind, welche über Lichtwellenleiter (34) miteinander verbindbar sind.

14. Vorrichtung zur Erzeugung elektrischer Energie,
**dadurch gekennzeichnet, dass**
die Vorrichtung eine Schaltschrankanordnung (64, 96, 98) nach einem der Ansprüche 1 bis 12 aufweist.

15. Vorrichtung zur Erzeugung elektrischer Energie nach Anspruch 14,
**dadurch gekennzeichnet, dass**
die Vorrichtung als Windenergieanlage (108) mit einem Generator (68), insbesondere als Windenergieanlage eines Offshore-Windparks ausgebildet ist.

## Claims

1. Switch cabinet arrangement of a device for generating electrical energy, wherein the switch cabinet arrangement (64, 96, 98) comprises at least two separate power switch cabinets (1, 1', 1", 36, 86),
**characterised in that**
the power switch cabinets (1, 1', 1", 36, 86) each comprise
- a machine-side connection (2),
- a power module (6),
- a mains-side connection (4), and
- a non-central control unit (32, 32', 32"),
wherein the power module (6) comprises
- a machine-side converter (8),
- a mains-side converter (10),
- a direct voltage intermediate circuit (12), and
- a chopper (14),
and wherein the power switch cabinets (1, 1', 1", 36, 86) are electrically connected in parallel to one another via the mains-side connection (2) and optionally via the machine-side connection (4),
**characterised in that**
the power module (6) comprises a plate-shaped direct current busbar (46), which comprises on a first side the power switch and a chopper (8', 10', 12, 42, 58, 60, 62) and on a second side the capacitors of the direct voltage intermediate circuit (20, 22, 48).

2. Switch cabinet arrangement according to claim 1,
**characterised in that**
alternatively the power switch cabinets (1, 1', 1", 36, 86) are each connected individually to the mains via associated secondary windings of one or a plurality of transformers.

3. Switch cabinet arrangement according to any one of claims 1 to 2,
**characterised in that**
the power switch cabinets (1, 1', 1", 36, 86) each comprise a dU/dt filter (30, 30', 30").

4. Switch cabinet arrangement according to any one of claims 1 to 3,
**characterised in that**
the power switch cabinets (1, 1', 1", 36, 86) comprise a line choke on the mains side.

5. Switch cabinet arrangement according to any one of claims 1 to 4,
**characterised in that**
the power switch cabinets (1, 1', 1", 36, 86) comprise on the mains-side connections (4) and/or on the machine-side connections (2), respectively, upstream connected devices for the electrical disconnection of the power switch cabinets (24, 26, 26', 26").

6. Switch cabinet arrangement according to any one of claims 1 to 5,
**characterised in that**
the power switch cabinets (1, 1', 1", 36, 86) each comprise a cooling device (38), in particular a heat exchanger (88).

7. Switch cabinet arrangement according to any one of claims 1 to 6,
**characterised in that**
the power switch cabinets (1, 1', 1", 36, 86) are hermetically sealed against the ambient air.

8. Switch cabinet arrangement according to any one of claims 1 to 7,
**characterised in that**
the power switch cabinets (1, 1', 1", 36, 86) are electrically connected in parallel by means of AC bars.

9. Switch cabinet arrangement according to any one of claims 1 to 8,
**characterised in that**
the power switch cabinets (1, 1', 1", 36, 86) are arranged laterally in series and/or back-to-back.

10. Switch cabinet arrangement according to any one of claims 1 to 9,
**characterised in that**
the switch cabinet arrangement (64, 96, 98) comprises a separate mains connection switch cabinet (72), which contains a central control unit (74).

11. Switch cabinet arrangement according to claim 10,
**characterised in that**
the mains connection switch cabinet (72) comprises at least one mains filter (78).

12. Switch cabinet arrangement according to claim 10 or 11,
**characterised in that**
the mains connection switch cabinet (72) comprises an auxiliary voltage supply (80) and/or a mains switch (76).

13. Switch cabinet arrangement according to any one of claims 1 to 12,
**characterised in that**
a central control unit (74) and non-central control units (32, 32', 32") are provided, which can be connected to one another via light wave conductors (34).

14. Device for generating electrical energy,
**characterised in that**
the device comprises a switch cabinet arrangement (64, 96, 98) according to any one of claims 1 to 13.

15. Device for generating electrical energy according to claim 14,
**characterised in that**
the device is designed as a wind energy plant (108) with a generator (68), in particular as a wind energy plant of an offshore wind farm.

## Revendications

1. Arrangement d'armoires électriques d'un dispositif pour la production d'énergie électrique, l'arrangement d'armoires électriques (64, 96, 98) comportant au moins deux armoires électriques de puissance (1, 1', 1", 36, 86) séparées,
**caractérisé en ce que**
les armoires électriques de puissance (1, 1', 1", 36, 86) comportent chacune
- une connexion côté machine (2),
- un module de puissance (6),
- une connexion côté réseau (4) et
- une unité de commande non centrale (32, 32', 32"),
dans lequel le module de puissance (6) comporte
- un convertisseur côté machine (8),
- un convertisseur côté réseau (10),
- un circuit intermédiaire en tension continue (12) et
- un hacheur (14),
et dans lequel les armoires électriques de puissance (1, 1', 1", 36, 86) sont connectées électriquement en parallèle les unes avec les autres via la connexion côté réseau (2) et, en option, via la connexion côté machine (4),
**caractérisé en ce que**
le module de puissance (6) comporte une barre de courant continu (46) en forme de plaque qui comporte les commutateurs de puissance et un hacheur (8', 10', 12, 42, 58, 60, 62) sur un premier côté et les condensateurs du circuit intermédiaire en tension continue (20, 22, 48) sur un deuxième côté..

2. Arrangement d'armoires électriques selon la revendication 1,
**caractérisé en ce que**
alternativement, les armoires électriques de puissance (1, 1', 1", 36, 86) sont chacune raccordées individuellement au réseau via des enroulements secondaires assignés d'un ou plusieurs transformateurs.

3. Arrangement d'armoires électriques selon l'une des revendications 1 à 2,
**caractérisé en ce que**
les armoires électriques de puissance (1, 1', 1", 36, 86) comportent chacune un filtre dU/dt (30, 30', 30").

4. Arrangement d'armoires électriques selon l'une des revendications 1 à 3,
**caractérisé en ce que**
les armoires électriques de puissance (1, 1', 1", 36, 86) comportent sur le côté du réseau une bobine de réseau.

5. Arrangement d'armoires électriques selon l'une des revendications 1 à 4,
**caractérisé en ce que**
les armoires électriques de puissance (1, 1', 1", 36, 86) comportent, aux connexions côté réseau (4) et/ou aux connexions côté machine (2), respectivement, des dispositifs connectés en amont pour la déconnexion électrique des armoires électriques de puissance (24, 26, 26', 26").

6. Arrangement d'armoires électriques selon l'une des revendications 1 à 5,
**caractérisé en ce que**
les armoires électriques de puissance (1, 1', 1", 36, 86) comportent chacune un dispositif de refroidissement (38), particulièrement un échangeur thermique (88).

7. Arrangement d'armoires électriques selon l'une des revendications 1 à 6,
**caractérisé en ce que**
les armoires électriques de puissance (1, 1', 1", 36, 86) sont hermétiquement fermées à l'air ambiant.

8. Arrangement d'armoires électriques selon l'une des revendications 1 à 7,
**caractérisé en ce que**
les armoires électriques de puissance (1, 1', 1", 36, 86) sont connectées électriquement en parallèle au moyen de barres AC.

9. Arrangement d'armoires électriques selon l'une des revendications 1 à 8,
**caractérisé en ce que**
les armoires électriques de puissance (1, 1', 1", 36, 86) sont arrangées latéralement en série et/ou dos à dos.

10. Arrangement d'armoires électriques selon l'une des revendications 1 à 9,
**caractérisé en ce que**
l'arrangement d'armoires électriques (64, 96, 98) comporte une armoire électrique de raccordement au réseau (72) séparée qui comporte une unité de commande centrale (74).

11. Arrangement d'armoires électriques selon la revendication 10,
**caractérisé en ce que**
l'armoire électrique de raccordement au réseau (72) comporte au moins un filtre de réseau (78).

12. Arrangement d'armoires électriques selon la revendication 10 ou 11,
**caractérisé en ce que**
l'armoire électrique de raccordement au réseau (72) comporte une alimentation en tension auxiliaire (80) et/ou un interrupteur de courant (76).

13. Arrangement d'armoires électriques selon l'une des revendications 1 à 12,
**caractérisé en ce que**
une unité de commande centrale (74) et des unités de commande non centrales (32, 32', 32") sont prévues, qui peuvent être reliées entre elles par des conducteurs d'ondes lumineuses (34).

14. Dispositif pour la production d'énergie électrique,
**caractérisé en ce que**
le dispositif comporte un arrangement d'armoires électriques (64, 96, 98) selon l'une des revendications 1 à 13.

15. Dispositif pour la production d'énergie électrique selon la revendication 14,
**caractérisé en ce que**
le dispositif est conçu comme une installation éolienne (108) avec un générateur (68), particulièrement comme une installation éolienne d'un parc éolien offshore.
